# EUROPEAN PATENT SPECIFICATION

(11) **EP 4 564 026 B1**
(45) Date of publication and mention of the grant of the patent: **30.09.2026**
(21) Application number: 23865733.2
(22) Date of filing: 09.08.2023
(51) Int. Cl.: G01R 31/367, G01R 31/396, G01R 31/392, H01M 10/42, B60L 3/00, B60L 58/16

(54) **BATTERY MANAGEMENT SYSTEM AND OPERATION METHOD THEREOF**
BATTERIEVERWALTUNGSSYSTEM UND BETRIEBSVERFAHREN DAFÜR
SYSTÈME DE GESTION DE BATTERIE ET SON PROCÉDÉ DE FONCTIONNEMENT

(30) Priority: 14.09.2022 KR 20220115949
(43) Date of publication of application: 04.06.2025
(73) Proprietor: LG Energy Solution, Ltd., Seoul 07335 (KR)
(72) Inventor: LEE, Bo Kyun, Daejeon 34122 (KR); PARK, Han Gon, Daejeon 34122 (KR)
(74) Representative: Plasseraud IP
(86) International application number: PCT/KR2023/011771
(87) International publication number: WO 2024/058433

(56) References cited:
- EP-A1- 4 019 321
- CN-A- 104 459 556
- CN-B- 111 273 176
- KR-A- 20140 068 192
- KR-A- 20210 004 646
- KR-A- 20210 094 505
- US-A1- 2011 298 626

## Description

### [TECHNICAL FIELD]

### TECHNICAL FIELD

Embodiments disclosed herein relate to a battery management apparatus and an operating method thereof.

### [BACKGROUND ART]

An electric vehicle is supplied with electricity from outside to charge a battery, and then a motor is driven by a voltage charged in the battery to obtain power. The battery of the electric vehicle may have heat generated therein by chemical reaction occurring in a process of charging and discharging electricity, and the heat may impair performance and lifetime of the battery. Thus, a battery management apparatus (or a battery management system (BMS)) that monitors and controls temperature, voltage, and current of the battery is driven to diagnose the state of the battery.

However, even when there is battery data continuously exceeding a threshold value among battery data measured in a process where the battery management apparatus diagnoses a battery, if a mature time where the battery data exceeds the threshold value does not reach a threshold time, the battery data may not be diagnosed and may be overlooked. Generally, a threshold time for battery diagnosis is set to a fixed value, to change the fixed threshold time, software of the vehicle having the battery mounted thereon needs to be updated, requiring significant time and cost during update. It is known for instance from document CN 111 273 176 B to perform an update of such threshold time.

### [DISCLOSURE]

### [TECHNICAL PROBLEM]

Embodiments disclosed herein aim to provide a battery management apparatus and an operating method thereof, in which the efficiency of battery data analysis may be improved by recording identification information of battery data exceeding a threshold value among data of a battery and flexibly changing a threshold time.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to the invention is defined by the appended claim 1.

### [ADVANTAGEOUS EFFECTS]

The battery management apparatus and the operating method thereof according to an embodiment disclosed herein may improve the efficiency of battery data analysis by recording identification information of battery data exceeding a threshold value among data of a battery and flexibly changing a threshold time.

### [DESCRIPTION OF DRAWINGS]

FIG. 1 illustrates a battery pack according to an embodiment disclosed herein.
FIG. 2 is a view for describing in detail a configuration of a battery management apparatus according to an embodiment disclosed herein.
FIG. 3 is a view of an operating method of a controller according to an embodiment disclosed herein.
FIG. 4 is a flowchart of an operating method of a battery management apparatus according to an embodiment disclosed herein.
FIG. 5 is a flowchart of an operating method of a battery management apparatus according to another embodiment disclosed herein.
FIG. 6 is a block diagram showing a hardware configuration of a computing system for performing an operating method of a battery management apparatus, according to an embodiment disclosed herein.

### [MODE FOR INVENTION]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

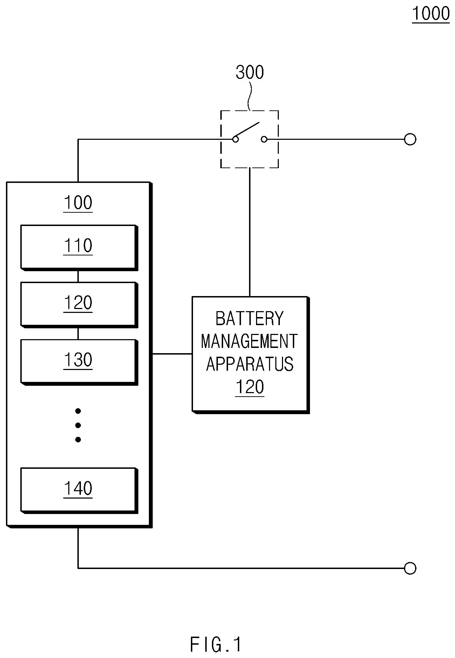

FIG. 1 illustrates a battery pack according to an embodiment disclosed herein.

Referring to FIG. 1, a battery pack 1000 according to an embodiment disclosed herein may include a battery module 100, a battery management apparatus 200, and a relay 300.

The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery management apparatus (a battery management system (BMS)) 200 may predict a life (a state of health (SoH)) of the plurality of battery cells 110, 120, 130, and 140 based on temperature and voltage data of the plurality of battery cells 110, 120, 130, and 140. The battery management apparatus 200 may remove noise from battery data of the plurality of battery cells 110, 120, 130, and 140 and predict a life (SoH) of the plurality of battery cells 110, 120, 130, and 140 for each of temperature and charge/discharge rate of a battery based on the noise-removed data.

The battery management apparatus 200 may manage and/or control a state and/or an operation of the battery module 100. For example, the battery management apparatus 200 may manage and/or control the states and/or operations of the plurality of battery cells 110, 120, 130, and 140 included in the battery module 100. The battery management apparatus 200 may manage charging and/or discharging of the battery module 100.

In addition, the battery management apparatus 200 may monitor a voltage, a current, a temperature, etc., of the battery module 100 and/or each of the plurality of battery cells 110, 120, 130, and 140 included in the battery module 100. A sensor or various measurement modules for monitoring performed by the battery management apparatus 200, which are not shown, may be additionally installed in the battery module 100, a charging/discharging path, any position of the battery module 100, etc. The battery management apparatus 200 may calculate a parameter indicating a state of the battery module 100, e.g., a state of charge (SoC), based on a measurement value such as monitored voltage, current, temperature, etc.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 1000.

The battery management apparatus 200 may calculate a cell balancing time of each of the plurality of battery cells 110, 120, 130, and 140. Herein, the cell balancing time may be defined as a time required for balancing of the battery cell. For example, the battery management apparatus 200 may calculate a cell balancing time based on an SoC, a battery capacity, and a balancing efficiency of each of the plurality of battery cells 110, 120, 130, and 140.

For the plurality of battery cells 110, 120, 130, and 140, as a period of use or the number of times of use increases, a capacity may decrease, internal resistance may increase, and various factors of the battery may change. The battery management apparatus 200 may calculate the life of the battery based on data of various factors changing with deterioration of the battery. More specifically, the battery management apparatus 200 may calculate the SoH of the plurality of battery cells 110, 120, 130, and 140 based on data of various factors changing with deterioration of the plurality of battery cells 110, 120, 130, and 140. The SoH is an index indicating a health state or life state of the battery in the current state with respect to an initial state of the battery. A moment at which the SoH reaches 0 % may be defined as an end of life (EoL). In addition, the end of life of the battery may be a moment at which the capacity of the battery reaches a guaranteed capacity or less. For example, the battery management apparatus 200 may calculate the SoH of the plurality of battery cells 110, 120, 130, and 140 based on at least any one factor of internal resistance, impedance, conductance, capacity, voltage, self-discharge current, charge performance, and the number of times of charge and discharge of the plurality of battery cells 110, 120, 130, and 140, which change with deterioration of the plurality of battery cells 110, 120, 130, and 140.

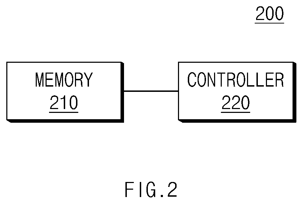

FIG. 2 is a view for describing in detail a configuration of a battery management apparatus according to an embodiment disclosed herein.

Hereinbelow, a configuration of the battery management apparatus 200 will be described in detail with reference to FIG. 2.

Referring to FIG. 2, the battery management apparatus 200 may include a memory 210 and a controller 220.

The memory 210 may store battery data of the plurality of battery cells 110, 120, 130, and 140. According to an embodiment, the memory 210 may temporarily store data to adjust a time difference or a speed difference of data transmission occurring when data is transmitted from a device to another device. The memory 210 may temporarily store battery data of the plurality of battery cells 110, 120, 130, and 140 at specific time intervals. Herein, the battery data may include voltage, current, temperature, a state of charge (SoC), a state of health (SoH), a power limit, or related diagnosis information of the battery.

The memory 210 may record identification information of battery data exceeding a threshold value among battery data. Herein, the identification information may include log data. The log data may be defined as data recording all event information occurring during execution of an operating system or software over time. For example, a value stored in the identification information may include communication raw data of the battery, a value of the battery data, a battery data measurement time, information of the battery where excess over a threshold value occurs, etc.

The controller 220 may analyze the battery data of the plurality of battery cells 110, 120, 130, and 140. The controller 220 may determine whether the battery data of the plurality of battery cells 110, 120, 130, and 140 exceed the threshold value. Herein, the threshold value may be defined as a criterion for determining 'abnormality' because an extreme result is output. That is, the threshold value may be defined as a criterion indicating a degree to which data contradicts a particular statistical model. More specifically, the controller 220 may determine at specific time intervals whether the battery data of the plurality of battery cells 110, 120, 130, and 140 exceed the threshold value. For example, the controller 220 may determine whether battery data of the plurality of battery cells 110, 120, 130, and 140 from a time (t - N) to a time (t - 1) exceed a preset threshold value.

The controller 220 may determine whether a mature time of battery data exceeding the threshold value exceeds a threshold time. Herein, the mature time may be defined as a minimum duration of a failure of the battery required for diagnosis of the battery based on the battery data. That is, the controller 220 may determine whether a mature time of battery data exceeding the threshold value, generated for a predetermined time, exceeds a preset threshold time.

The controller 220 may diagnose the battery when the mature time of the battery data exceeding the threshold value exceeds the threshold time. For example, the controller 220 may diagnose a first battery cell 110 when a mature time of battery data exceeding the threshold value among battery data of the first battery cell 110 lasts for several seconds to several tens of seconds. Moreover, the controller 220 may determine at specific time intervals whether the mature time of the battery data exceeding the threshold value exceeds a preset threshold time.

For example, when the mature time of the battery data exceeding the threshold value exceeds the threshold time, the controller 220 may diagnose a SoC, which is a battery capacity for predicting a drivable distance of the battery pack 1000, and a SoH, which is aging life prediction for battery replacement. Herein, the battery capacity for drivable distance prediction is a ratio of the remaining charge amount to the charge amount, and the controller 220 may determine the current charge amount remaining in the battery pack 1000 by sensing current, voltage, temperature, etc., to predict the remaining driving distance of the vehicle.

The controller 220 may diagnose a failure of the battery system when the mature time of the battery data exceeding the threshold value exceeds the threshold time. For example, when the mature time of the battery data exceeding the threshold value exceeds the threshold time, the controller 220 may detect various failures of a battery system such as over-voltage, low-voltage, a battery cell failure, a current sensor failure, a temperature sensor failure, disconnection, shortcircuit, a cooling fan failure, a communication error, relay fusion, etc., and transmit failure detection information to other controllers.

The controller 220 may record the identification information of the battery data based on a result of the determination. According to an embodiment, when the mature time of the battery data exceeding the threshold value is less than the threshold time, the controller 220 may accumulatively record the identification information of the battery data exceeding the threshold value. More specifically, when the mature time of the battery data exceeding the threshold value is less than the threshold time, the controller 220 may accumulatively record the mature time of the battery data exceeding the threshold value and the number of times of occurrence of the battery data exceeding the threshold value in the memory 210.

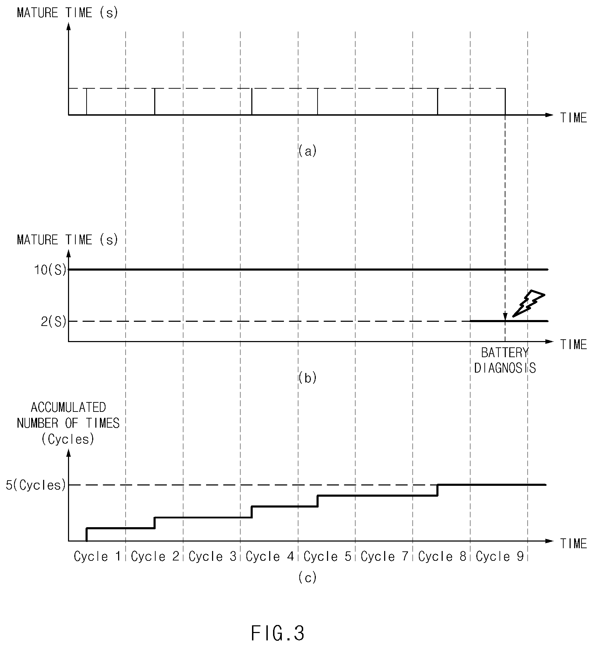

FIG. 3 is a view of an operating method of a controller according to an embodiment disclosed herein.

Referring to (a) of FIG. 3, when the mature time of the battery data exceeding the threshold value is less than the threshold time, the controller 220 may record the identification information of the battery data exceeding the threshold value. For example, when a mature time required for diagnosing the battery data is 10 S(Sec) and a measured mature time of the battery data exceeding the threshold value is 2 S, the controller 220 may record data including 2 S that is the mature time of the battery data exceeding the threshold value and 6 that is the number of times of occurrence of the battery data.

Referring to (b) of FIG. 3, when the mature time of the battery data exceeding the threshold value is less than the threshold time, the controller 220 may accumulatively record the mature time of the battery data exceeding the threshold value. The controller 220 may also calculate an accumulated time of the battery data exceeding the threshold value based on the accumulatively recorded mature time of the battery data exceeding the threshold value. When the mature time of the battery data exceeding the threshold value is less than the threshold time, the controller 220 may accumulatively record a mature time for which the battery data exceeding the threshold value occurs in the memory 210 to calculate the accumulated time.

For example, when a mature time required for diagnosing the battery data is 10 S(Sec) and a measured mature time of the battery data exceeding the threshold value is 2 S, the controller 220 may accumulatively record 2 S that is the mature time of the battery data exceeding the threshold value.

Referring to (c) of FIG. 3, when the mature time of the battery data exceeding the threshold value is less than the threshold time, the controller 220 may accumulatively record the number of times of occurrence of the battery data exceeding the threshold value. The controller 220 may also calculate an accumulated number of times of the battery data exceeding the threshold value based on the accumulatively recorded number of times of occurrence of the battery data exceeding the threshold value. Herein, the number of times of occurrence may include, for example, a cycle of the battery management apparatus. The cycle of the battery management apparatus may include an operating period of the battery management apparatus 200 such as Power ON/OFF, Ignition ON/OFF, etc., of the battery management apparatus. The controller 220 may increase the number of times of occurrence by accumulating the number of times of occurrence of the battery data exceeding the threshold value.

For example, when a mature time required for diagnosing the battery data is 10 S(Sec) and a measured mature time of the battery data exceeding the threshold value is 2 S, the controller 220 may accumulatively record the number of times of occurrence of the battery data exceeding the threshold value.

The controller 220 may determine whether the accumulated number of times is greater than or equal to a reference value. The controller 220 may recalculate the threshold time by dividing the accumulated time by the accumulated number of times, when the number of times is greater than or equal to the reference value. More specifically, when the accumulated number of times is greater than or equal to the reference value, the controller 220 may set, as the threshold time, a value calculated by dividing the accumulated time by the accumulated number of times, to change a battery diagnosis condition.

For example, when the accumulated number of times is greater than or equal to the reference value of 5 cycles, the controller 220 may change the threshold time by recalculating the threshold time. When the accumulated time is 10 S and the accumulated number of times is greater than or equal to 5 cycles, the controller 220 may recalculate, as the threshold time, 2S that is calculated by dividing the accumulated time, 10 S, by the accumulated number of times, 5 cycles. The controller 220 may change the battery diagnosis condition by setting the recalculated 2 S as the threshold time.

The controller 220 may determine whether the mature time of the battery data exceeding the threshold value exceeds the threshold time, based on the recalculated threshold time. The controller 220 may perform diagnosis of the battery data having the mature time exceeding the threshold time. For example, the controller 220 may set 2 S as the threshold time to change the battery diagnosis condition and then perform diagnosis of the battery when the mature time of the battery data exceeding the threshold value is 2 S.

Embodiments disclosed herein aim to provide a battery management apparatus and an operating method thereof in which it may be determined whether voltage data of a battery exceeds a threshold count value to early diagnose deterioration of the battery and to improve efficiency and speed of battery diagnosis, thereby preventing fire.

As described above, the battery management apparatus 200 and the operating method thereof according to an embodiment disclosed herein may improve the efficiency of battery data analysis by recording identification information of battery data exceeding a threshold value among data of a battery and flexibly changing a threshold time.

In addition, the battery management apparatus 200 may analyze a time point at which and a trend in which the mature time of the battery data greater than or equal to the threshold count value occurs, thereby improving the accuracy of the battery diagnosis and predicting occurrence of diagnosis.

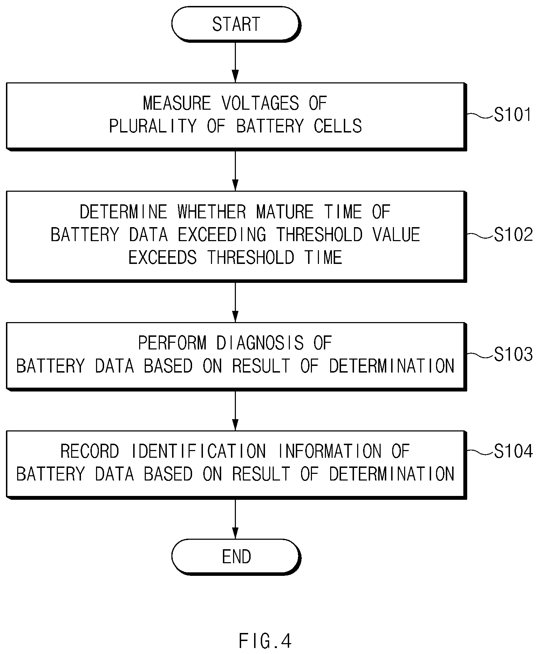

FIG. 4 is a flowchart of an operating method of a battery management apparatus according to an embodiment disclosed herein. Hereinbelow, an operating method of the battery management apparatus 200 will be described with reference to FIGS. 1 and 3.

The battery management apparatus 200 may be substantially the same as the battery management apparatus 200 described with reference to FIGS. 1 to 3, and thus will be briefly described to avoid redundant description.

Referring to FIG. 4, the operating method of the battery management apparatus 200 may include operation S101 of determining whether battery data exceeds a threshold value, operation S102 of determining whether a mature time of the battery data exceeding the threshold value exceeds a threshold time, operation S103 of performing diagnosis of the battery data based on a result of the determination, and operation S104 of recording identification information of the battery data based on a result of the determination.

Hereinbelow, operations S101 through S104 will be described in detail.

In operation S101, the controller 220 may analyze the battery data of the plurality of battery cells 110, 120, 130, and 140. In operation S101, the controller 220 may determine whether the battery data of the plurality of battery cells 110, 120, 130, and 140 exceed the threshold value. Herein, the threshold value may be defined as a criterion for determining 'abnormality' because an extreme result is output. That is, the threshold value may be defined as a criterion indicating a degree to which data contradicts a particular statistical model.

In operation S101, more specifically, the controller 220 may determine at specific time intervals whether the battery data of the plurality of battery cells 110, 120, 130, and 140 exceed the threshold value. In operation S101, for example, the controller 220 may determine whether battery data of the plurality of battery cells 110, 120, 130, and 140 from the time (t - N) to the time (t - 1) exceed the preset threshold value.

In operation S102, the controller 220 may determine whether the mature time of the battery data exceeding the threshold value exceeds the threshold time. Herein, the mature time may be defined as a minimum duration of a failure of the battery required for diagnosis of the battery based on the battery data.

In operation S102, the controller 220 may determine whether the mature time of the battery data exceeding the threshold value, generated for a predetermined time, exceeds the preset threshold time.

In operation S103, the controller 220 may diagnose the battery when the mature time of the battery data exceeding the threshold value exceeds the threshold time. In operation S103, for example, the controller 220 may diagnose the first battery cell 110 when the mature time of the battery data of the first battery cell 110 exceeding the threshold value, measured for the predetermined time, exceeds the threshold time.

In operation S103, for example, the controller 220 may diagnose the first battery cell 110 when the mature time of the battery data exceeding the threshold value among the battery data of the first battery cell 110 lasts for several seconds to several tens of seconds. Moreover, the controller 220 may determine at specific time intervals whether the mature time of the battery data exceeding the threshold value exceeds a preset threshold time.

In operation S104, the controller 220 may record the identification information of the battery data in the memory 210 based on a result of the determination.

In operation S104, according to an embodiment, when the mature time of the battery data exceeding the threshold value is less than the threshold time, the controller 220 may accumulatively record the identification information of the battery data exceeding the threshold value. Herein, the identification information may include log data. The log data may be defined as data recording all event information occurring during execution of an operating system or software over time. For example, a value stored in the identification information may include communication raw data of the battery, a value of the battery data, a battery data measurement time, information of the battery where excess over a threshold value occurs, etc.

In operation S104, more specifically, when the mature time of the battery data exceeding the threshold value is less than the threshold time, the controller 220 may accumulatively record the mature time of the battery data exceeding the threshold value and the number of times of occurrence of the battery data exceeding the threshold value in the memory 210.

In operation S104, for example, when the mature time required for diagnosing the battery data is 10 S(Sec) and the measured mature time of the battery data exceeding the threshold value is 2 S, the controller 220 may record data including 2 S that is the mature time of the battery data exceeding the threshold value and 6 that is the number of times of occurrence of the battery data.

In operation S104, when the mature time of the battery data exceeding the threshold value is less than the threshold time, the controller 220 may accumulatively record the number of times of occurrence of the battery data exceeding the threshold value.

In operation S104, the controller 220 may also calculate the accumulated number of times of the battery data exceeding the threshold value based on the accumulatively recorded number of times of occurrence of the battery data exceeding the threshold value. In operation S104, the controller 220 may increase the number of times of occurrence by accumulating the number of times of occurrence of the battery data exceeding the threshold value.

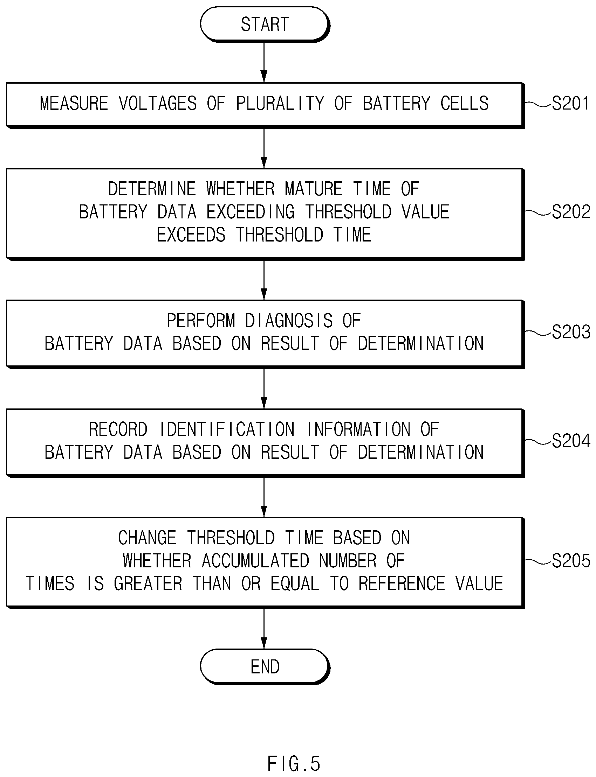

FIG. 5 is a flowchart of an operating method of a battery management apparatus according to another embodiment disclosed herein.

Referring to FIG. 5, the operating method of the battery management apparatus 200 may include operation S201 of determining whether battery data exceeds a threshold value, operation S202 of determining whether a mature time of the battery data exceeding the threshold value exceeds a threshold time, operation S203 of performing diagnosis of the battery data based on a result of the determination, operation S204 of recording an accumulated time and an accumulated number of times of the battery data based on a result of the determination, and operation S205 of determining whether the accumulated number of times is greater than or equal to the reference time and changing the threshold time based on whether the accumulated number of times is greater than or equal to the reference value.

In operation S201, the controller 220 may analyze the battery data of the plurality of battery cells 110, 120, 130, and 140. In operation S201, the controller 220 may determine whether the battery data of the plurality of battery cells 110, 120, 130, and 140 exceed the threshold value.

In operation S202, the controller 220 may determine whether the mature time of the battery data exceeding the threshold value exceeds the threshold time. Herein, the mature time may be defined as a minimum duration of a failure of the battery required for diagnosis of the battery based on the battery data.

In operation S203, the controller 220 may diagnose the battery when the mature time of the battery data exceeding the threshold value exceeds the threshold time.

In operation S204, the controller 220 may record the identification information of the battery data based on a result of the determination. In operation S204, according to an embodiment, when the mature time of the battery data exceeding the threshold value is less than the threshold time, the controller 220 may accumulatively record the identification information of the battery data exceeding the threshold value, in the memory 210.

In operation S204, more specifically, when the mature time of the battery data exceeding the threshold value is less than the threshold time, the controller 220 may accumulatively record the mature time of the battery data exceeding the threshold value and the number of times of occurrence of the battery data exceeding the threshold value in the memory 210.

In operation S204, when the mature time of the battery data exceeding the threshold value is less than the threshold time, the controller 220 may calculate the accumulated time of the battery data exceeding the threshold value. When the mature time of the battery data exceeding the threshold value is less than the threshold time, the controller 220 may accumulatively record a mature time for which the battery data exceeding the threshold value occurs in the memory 210 to calculate the accumulated time.

In operation S205, the controller 220 may determine whether the accumulated number of times is greater than or equal to the reference value. In operation S205, the controller 220 may recalculate the threshold time by dividing the accumulated time by the accumulated number of times, when the number of times of occurrence is greater than or equal to the reference value. In operation S205, more specifically, when the accumulated number of times is greater than or equal to the reference value, the controller 220 may set, as the threshold time, a value calculated by dividing the accumulated time by the accumulated number of times, to change a battery diagnosis condition.

In operation S205, for example, when the accumulated number of times is greater than or equal to the reference value of 5 cycles, the controller 220 may change the threshold time by recalculating the threshold time. In operation S205, when the accumulated time is 10 S and the accumulated number of times is greater than or equal to 5 cycles, the controller 220 may recalculate, as the threshold time, 2 S that is calculated by dividing the accumulated time, 10 S, by the accumulated number of times, 5 cycles.

In operation S205, the controller 220 may change the battery diagnosis condition by setting the recalculated 2 S as the threshold time. In operation S205, the controller 220 may determine whether the mature time of the battery data exceeding the threshold value exceeds the threshold time, based on the recalculated threshold time.

In operation S205, the controller 220 may perform diagnosis of the battery data having the mature time exceeding the threshold time. In operation S205, for example, the controller 220 may set 2 S as the threshold time to change the battery diagnosis condition and then perform diagnosis of the battery when the mature time of the battery data exceeding the threshold value is 2 S.

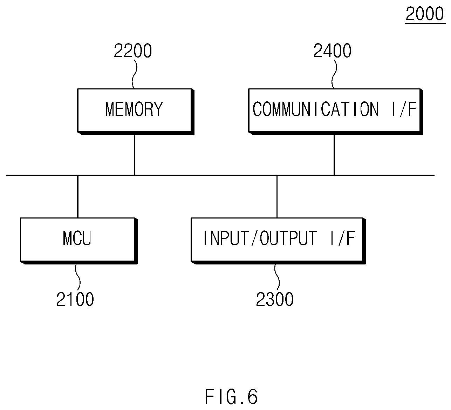

FIG. 6 is a block diagram showing a hardware configuration of a computing system for performing an operating method of a battery management apparatus, according to an embodiment disclosed herein.

Referring to FIG. 6, a computing system 2000 according to an embodiment disclosed herein may include an MCU 2100, a memory 2200, an input/output I/F 2300, and a communication I/F 2400.

The MCU 2100 may be a processor that executes various programs (e.g., a battery data diagnosis program, etc.) stored in the memory 2200, processes various data through these programs, and perform the above-described functions of the battery management apparatus 200 shown in FIG. 1.

The memory 2200 may store various programs regarding operations of the computing system 2000. Moreover, the memory 2200 may store operation data of the computing system 2000.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

### [Explanation of Reference Numerals]

1000: Battery Pack
100: Battery Module
110: First Battery Cell
120: Second Battery Cell
130: Third Battery Cell
140: Fourth Battery Cell
200: Battery Management Apparatus
210: Memory
220: Controller
300: Relay
200: Computing System
2100: MCU
2200: Memory
2300: Input/Output I/F
2400: Communication I/F

## Claims

1. A battery management apparatus comprising:
a memory; and
a controller configured to determine whether battery data exceeds a threshold value, said threshold value corresponding to a criterion for determining an abnormality, and whether a mature time of battery data exceeding the threshold value exceeds a threshold time, said mature time being defined as a minimum duration of a failure of a battery required for diagnosis of the battery based on the battery data, perform diagnosis of the battery data and detect a type of failure of the battery based on a result of the determination of whether the mature time of battery data exceeding the threshold value exceeds the threshold time, and record identification information of the battery data in the memory based on a result of the determination of whether the mature time of battery data exceeding the threshold value exceeds the threshold time,
wherein said identification information comprises communication log data, communication raw data of the battery, a value of the battery data, a battery data measurement time, and/or information of the battery where excess over a threshold value occurs,
wherein, when the mature time of the battery data exceeding the threshold value is less than the threshold time, the controller is further configured to:
- accumulatively record the identification information of the battery data exceeding the threshold value in the memory,
- accumulatively record, in the memory, the mature time of the battery data exceeding the threshold value and a number of times of occurrence of the battery data exceeding the threshold value,
- calculate an accumulated time of the battery data exceeding the threshold value based on the accumulatively recorded mature time of the battery data exceeding the threshold value and calculate an accumulated number of times of the battery data exceeding the threshold value based on the number of times of occurrence of the battery data exceeding the threshold value, to determine whether the accumulated number of times is greater than or equal to a reference value and change the threshold time based on whether the accumulated number of times is greater than or equal to the reference value,
- recalculate the threshold time by dividing the accumulated time by the accumulated number of times when the accumulated number of times is greater than or equal to the reference value, and
- diagnose if the battery is faulty according to the recalculated threshold time

2. The battery management apparatus of claim 1, wherein the controller is further configured to determine whether the mature time of the battery data exceeding the threshold value exceeds the threshold time, based on the recalculated threshold time.

3. An operating method of a battery management apparatus, implementing a controller, the operating method comprising:
determining whether battery data exceeds a threshold value, said threshold value corresponding to a criterion for determining an abnormality;
determining whether a mature time of the battery data exceeding the threshold value exceeds a threshold time, said mature time being defined as a minimum duration of a failure of a battery required for diagnosis of the battery based on the battery data;
performing diagnosis of the battery data and detect a type of failure based on a result of the determination of whether the mature time of battery data exceeding the threshold value exceeds the threshold time; and
recording identification information of the battery data based on a result of the determination of whether the mature time of battery data exceeding the threshold value exceeds the threshold time,
wherein said identification information comprises communication log data, communication raw data of the battery, a value of the battery data, a battery data measurement time, and/or information of the battery where excess over a threshold value occurs,
wherein, when the mature time of the battery data exceeding the threshold value is less than the threshold time, the recording of the identification information of the battery data based on the result of the determination comprises:
- accumulatively recording the identification information of the battery data exceeding the threshold value,
- accumulatively recording the mature time of the battery data exceeding the threshold value and a number of times of occurrence of the battery data exceeding the threshold value,
- calculating an accumulated time of the battery data exceeding the threshold value based on the accumulatively recorded mature time of the battery data exceeding the threshold value and calculate an accumulated number of times of the battery data exceeding the threshold value based on the number of times of occurrence of the battery data exceeding the threshold value,
the method further comprising determining whether the accumulated number of times is greater than or equal to a reference value and changing the threshold time based on whether the accumulated number of times is greater than or equal to the reference value and comprises recalculating the threshold time by dividing the accumulated time by the accumulated number of times when the accumulated number of times is greater than or equal to the reference value,
and diagnosing if the battery is faulty according to the recalculated threshold time

4. The operating method of claim 3, wherein the determining of whether the accumulated number of times is greater than or equal to a reference value and changing the threshold time based on whether the accumulated number of times is greater than or equal to the reference value comprises determining whether the mature time of the battery data exceeding the threshold value exceeds the threshold time, based on the recalculated threshold time.

## Patentansprüche

1. Batteriemanagementvorrichtung, umfassend:
einen Speicher; und
eine Steuereinheit, die konfiguriert ist, um zu bestimmen, ob Batteriedaten einen Schwellenwert überschreiten, wobei der genannte Schwellenwert einem Kriterium zur Bestimmung einer Abnormalität entspricht, und ob eine Reifezeit von Batteriedaten, die den Schwellenwert überschreiten, eine Schwellenzeit überschreitet, wobei die genannte Reifezeit als eine Mindestdauer eines Ausfalls einer Batterie definiert ist, die für die Diagnose der Batterie auf der Grundlage der Batteriedaten erforderlich ist, eine Diagnose der Batteriedaten durchzuführen und eine Art des Ausfalls der Batterie auf der Grundlage eines Ergebnisses der Bestimmung, ob die Reifezeit der Batteriedaten, die den Schwellenwert überschreiten, die Schwellenzeit überschreitet, zu erfassen, und Identifikationsinformationen der Batteriedaten in dem Speicher auf der Grundlage eines Ergebnisses der Bestimmung, ob die Reifezeit der Batteriedaten, die den Schwellenwert überschreiten, die Schwellenzeit überschreitet, aufzuzeichnen,
wobei die genannten Identifikationsinformationen Kommunikationsprotokolldaten, Kommunikationsrohdaten der Batterie, einen Wert der Batteriedaten, eine Batteriedatenmesszeit und/oder Informationen der Batterie, bei der eine Überschreitung eines Schwellenwerts auftritt, umfassen,
wobei, wenn die Reifezeit der Batteriedaten, die den Schwellenwert überschreiten, kürzer als die Schwellenzeit ist, die Steuereinheit ferner konfiguriert ist, um:
- die Identifikationsinformationen der Batteriedaten, die den Schwellenwert überschreiten, kumulativ im Speicher aufzuzeichnen;
- die Reifezeit der Batteriedaten, die den Schwellenwert überschreiten, und eine Anzahl des Auftretens der Batteriedaten, die den Schwellenwert überschreiten, kumulativ im Speicher aufzuzeichnen;
- eine kumulierte Zeit der Batteriedaten, die den Schwellenwert überschreiten, basierend auf der kumulativ aufgezeichneten Reifezeit der Batteriedaten, die den Schwellenwert überschreiten, zu berechnen und eine kumulierte Anzahl der Batteriedaten, die den Schwellenwert überschreiten, basierend auf der Anzahl des Auftretens der Batteriedaten, die den Schwellenwert überschreiten, zu berechnen;
- zu bestimmen, ob die kumulierte Anzahl größer oder gleich einem Referenzwert ist, und die Schwellenzeit basierend darauf zu ändern, ob die kumulierte Anzahl größer oder gleich dem Referenzwert ist;
- die Schwellenzeit neu zu berechnen, indem die kumulierte Zeit durch die kumulierte Anzahl geteilt wird, wenn die kumulierte Anzahl größer oder gleich dem Referenzwert ist; und
- zu diagnostizieren, ob die Batterie gemäß der neu berechneten Schwellenzeit fehlerhaft ist.

2. Die Batteriemanagementvorrichtung nach Anspruch 1, wobei die Steuereinheit ferner konfiguriert ist, um auf der Grundlage der neu berechneten Schwellenzeit zu bestimmen, ob die Reifezeit der Batteriedaten, die den Schwellenwert überschreiten, die Schwellenzeit überschreitet.

3. Betriebsverfahren einer Batteriemanagementvorrichtung, das eine Steuereinheit implementiert, wobei das Betriebsverfahren umfasst:
das Bestimmen, ob Batteriedaten einen Schwellenwert überschreiten, wobei der genannte Schwellenwert einem Kriterium zur Bestimmung einer Abnormalität entspricht;
das Bestimmen, ob eine Reifezeit von Batteriedaten, die den Schwellenwert überschreiten, eine Schwellenzeit überschreitet, wobei die genannte Reifezeit als eine Mindestdauer eines Ausfalls einer Batterie definiert ist, die für die Diagnose der Batterie auf der Grundlage der Batteriedaten erforderlich ist;
das Durchführen einer Diagnose der Batteriedaten und das Erfassen einer Art des Ausfalls auf der Grundlage eines Ergebnisses der Bestimmung, ob die Reifezeit der Batteriedaten, die den Schwellenwert überschreiten, die Schwellenzeit überschreitet; und
das Aufzeichnen von Identifikationsinformationen der Batteriedaten auf der Grundlage eines Ergebnisses der Bestimmung, ob die Reifezeit der Batteriedaten, die den Schwellenwert überschreiten, die Schwellenzeit überschreitet,
wobei die genannten Identifikationsinformationen Kommunikationsprotokolldaten, Kommunikationsrohdaten der Batterie, einen Wert der Batteriedaten, eine Batteriedatenmesszeit und/oder Informationen der Batterie, bei der eine Überschreitung eines Schwellenwerts auftritt, umfassen,
wobei, wenn die Reifezeit der Batteriedaten, die den Schwellenwert überschreiten, kürzer als die Schwellenzeit ist, das Aufzeichnen der Identifikationsinformationen der Batteriedaten auf der Grundlage des Ergebnisses der Bestimmung umfasst:
das kumulative Aufzeichnen der Identifikationsinformationen der Batteriedaten, die den Schwellenwert überschreiten;
das kumulative Aufzeichnen der Reifezeit der Batteriedaten, die den Schwellenwert überschreiten, und einer Anzahl des Auftretens der Batteriedaten, die den Schwellenwert überschreiten;
das Berechnen einer kumulierten Zeit der Batteriedaten, die den Schwellenwert überschreiten, basierend auf der kumulativ aufgezeichneten Reifezeit der Batteriedaten, die den Schwellenwert überschreiten, und das Berechnen einer kumulierten Anzahl der Batteriedaten, die den Schwellenwert überschreiten, basierend auf der Anzahl des Auftretens der Batteriedaten, die den Schwellenwert überschreiten,
wobei das Verfahren ferner umfasst:
das Bestimmen, ob die kumulierte Anzahl größer oder gleich einem Referenzwert ist, und das Ändern der Schwellenzeit basierend darauf, ob die kumulierte Anzahl größer oder gleich dem Referenzwert ist;
das Neuberechnen der Schwellenzeit durch Teilen der kumulierten Zeit durch die kumulierte Anzahl, wenn die kumulierte Anzahl größer oder gleich dem Referenzwert ist; und
das Diagnostizieren, ob die Batterie gemäß der neu berechneten Schwellenzeit fehlerhaft ist.

4. Das Betriebsverfahren nach Anspruch 3, wobei das Bestimmen, ob die kumulierte Anzahl größer oder gleich einem Referenzwert ist, und das Ändern der Schwellenzeit basierend darauf, ob die kumulierte Anzahl größer oder gleich dem Referenzwert ist, das Bestimmen umfasst, ob die Reifezeit der Batteriedaten, die den Schwellenwert überschreiten, die Schwellenzeit überschreitet, basierend auf der neu berechneten Schwellenzeit.

## Revendications

1. Appareil de gestion de batterie comprenant :
une mémoire ; et
un contrôleur configuré pour déterminer si des données de batterie dépassent une valeur seuil, ladite valeur seuil correspondant à un critère pour déterminer une anomalie, et si un temps de maturation des données de batterie dépassant la valeur seuil dépasse un temps seuil, ledit temps de maturation étant défini comme une durée minimale d'une défaillance d'une batterie requise pour le diagnostic de la batterie sur la base des données de batterie, effectuer un diagnostic des données de batterie et détecter un type de défaillance de la batterie sur la base d'un résultat de la détermination si le temps de maturation des données de batterie dépassant la valeur seuil dépasse le temps seuil, et enregistrer des informations d'identification des données de batterie dans la mémoire sur la base d'un résultat de la détermination si le temps de maturation des données de batterie dépassant la valeur seuil dépasse le temps seuil,
dans lequel lesdites informations d'identification comprennent des données de journal de communication, des données brutes de communication de la batterie, une valeur des données de batterie, un temps de mesure des données de batterie, et/ou des informations de la batterie où un dépassement d'une valeur seuil se produit,
dans lequel, lorsque le temps de maturation des données de batterie dépassant la valeur seuil est inférieur au temps seuil, le contrôleur est en outre configuré pour :
enregistrer de manière cumulative les informations d'identification des données de batterie dépassant la valeur seuil dans la mémoire ;
enregistrer de manière cumulative, dans la mémoire, le temps de maturation des données de batterie dépassant la valeur seuil et un nombre d'occurrences des données de batterie dépassant la valeur seuil ;
calculer un temps cumulé des données de batterie dépassant la valeur seuil sur la base du temps de maturation enregistré de manière cumulative des données de batterie dépassant la valeur seuil et calculer un nombre cumulé de fois des données de batterie dépassant la valeur seuil sur la base du nombre d'occurrences des données de batterie dépassant la valeur seuil ;
déterminer si le nombre cumulé de fois est supérieur ou égal à une valeur de référence et changer le temps seuil sur la base du fait que le nombre cumulé de fois est supérieur ou égal à la valeur de référence ;
recalculer le temps seuil en divisant le temps cumulé par le nombre cumulé de fois lorsque le nombre cumulé de fois est supérieur ou égal à la valeur de référence ; et
diagnostiquer si la batterie est défectueuse selon le temps seuil recalculé.

2. L'appareil de gestion de batterie de la revendication 1, dans lequel le contrôleur est en outre configuré pour déterminer si le temps de maturation des données de batterie dépassant la valeur seuil dépasse le temps seuil, sur la base du temps seuil recalculé.

3. Procédé de fonctionnement d'un appareil de gestion de batterie, mettant en œuvre un contrôleur, le procédé de fonctionnement comprenant :
la détermination si des données de batterie dépassent une valeur seuil, ladite valeur seuil correspondant à un critère pour déterminer une anomalie ;
la détermination si un temps de maturation des données de batterie dépassant la valeur seuil dépasse un temps seuil, ledit temps de maturation étant défini comme une durée minimale d'une défaillance d'une batterie requise pour le diagnostic de la batterie sur la base des données de batterie ;
la réalisation d'un diagnostic des données de batterie et la détection d'un type de défaillance sur la base d'un résultat de la détermination si le temps de maturation des données de batterie dépassant la valeur seuil dépasse le temps seuil ; et
l'enregistrement d'informations d'identification des données de batterie sur la base d'un résultat de la détermination si le temps de maturation des données de batterie dépassant la valeur seuil dépasse le temps seuil,
dans lequel lesdites informations d'identification comprennent des données de journal de communication, des données brutes de communication de la batterie, une valeur des données de batterie, un temps de mesure des données de batterie, et/ou des informations de la batterie où un dépassement d'une valeur seuil se produit,
dans lequel, lorsque le temps de maturation des données de batterie dépassant la valeur seuil est inférieur au temps seuil, l'enregistrement des informations d'identification des données de batterie sur la base du résultat de la détermination comprend :
l'enregistrement cumulatif des informations d'identification des données de batterie dépassant la valeur seuil ;
l'enregistrement cumulatif du temps de maturation des données de batterie dépassant la valeur seuil et d'un nombre d'occurrences des données de batterie dépassant la valeur seuil ;
le calcul d'un temps cumulé des données de batterie dépassant la valeur seuil sur la base du temps de maturation enregistré de manière cumulative des données de batterie dépassant la valeur seuil et le calcul d'un nombre cumulé de fois des données de batterie dépassant la valeur seuil sur la base du nombre d'occurrences des données de batterie dépassant la valeur seuil,
le procédé comprenant en outre :
la détermination si le nombre cumulé de fois est supérieur ou égal à une valeur de référence et le changement du temps seuil sur la base du fait que le nombre cumulé de fois est supérieur ou égal à la valeur de référence ;
le recalcul du temps seuil en divisant le temps cumulé par le nombre cumulé de fois lorsque le nombre cumulé de fois est supérieur ou égal à la valeur de référence ; et
le diagnostic si la batterie est défectueuse selon le temps seuil recalculé.

4. Le procédé de fonctionnement de la revendication 3, dans lequel la détermination si le nombre cumulé de fois est supérieur ou égal à une valeur de référence et le changement du temps seuil sur la base du fait que le nombre cumulé de fois est supérieur ou égal à la valeur de référence comprend la détermination si le temps de maturation des données de batterie dépassant la valeur seuil dépasse le temps seuil, sur la base du temps seuil recalculé.
